# EUROPÄISCHE PATENTSCHRIFT

(11) **EP 3 776 326 B1**
(45) Veröffentlichungstag und Bekanntmachung des Hinweises auf die Patenterteilung: **27.09.2023**
(21) Anmeldenummer: 19713778.9
(22) Anmeldetag: 26.03.2019
(51) Int. Cl.: G06K 7/08

(54) **MIT EINER INDIVIDUELLEN KENNUNG VERSEHENES BAUTEIL EINER CVD-VORRICHTUNG SOWIE VERFAHREN ZUR ÜBERMITTLUNG VON INFORMATIONEN**
CVD DEVICE COMPONENT PROVIDED WITH AN INDIVIDUAL IDENTIFIER, AND METHOD FOR COMMUNICATING INFORMATION
MODULE D'UN DISPOSITIF DE CVD POURVU D'UNE DÉSIGNATION INDIVIDUELLE ET PROCÉDÉ DE TRANSFERT D'INFORMATIONS

(30) Priorität: 26.03.2018 DE 102018107135
(43) Veröffentlichungstag der Anmeldung: 17.02.2021
(73) Patentinhaber: Aixtron SE, 52134 Herzogenrath (DE)
(72) Erfinder: BODE, Matthias Johannes, 4851 Gemmenich (BE); SCHMITT, Thomas, 41189 Mönchengladbach (DE); FRANKE, Micha Cornel, 52134 Herzogenrath (DE); MOHNEN, Markus, 52134 Herzogenrath (DE)
(74) Vertreter: Grundmann, Dirk
(86) Internationale Anmeldenummer: PCT/EP2019/057493
(87) Internationale Veröffentlichungsnummer: WO 2019/185574

(56) Entgegenhaltungen:
- DE-A1- 4 306 209
- DE-A1-102013 114 412

## Beschreibung

### Gebiet der Technik

Die Erfindung betrifft ein Bauteil einer Vorrichtung zur thermischen Behandlung zumindest eines Substrates, wobei das Bauteil bei der thermischen Behandlung mit einer Heizeinrichtung auf eine Temperatur aufgeheizt wird, bei der mit einem Temperatursensor, beispielsweise einem Infrarot-Sensor Oberflächenbereiche voneinander verschieden strukturierter Volumenbereiche des Bauteils anhand der Höhe des Sensorsignales voneinander unterscheidbar sind.

Die Erfindung betrifft ferner eine Vorrichtung zur thermischen Behandlung zumindest eines Substrates mit zumindest einer Steuereinrichtung und einem Bauteil, das bei der thermischen Behandlung mit einer Heizeinrichtung auf eine Temperatur aufgeheizt wird, bei der mit einem Sensor Oberflächenbereiche voneinander verschiedenen strukturierten Bereichen des Bauteiles anhand der Höhe des Sensorsignales voneinander unterscheidbar sind.

Die Erfindung betrifft darüber hinaus ein Verfahren.

### Stand der Technik

Bauteile, die Bestandteile eines CVD-Reaktors sind, werden u.a. beschrieben im EP 2 160 759 B1, DE 10 2013 012 082 A1, DE 10 2012 108 986 A1 oder DE 10 2008 055 582 A1.

Aus den US 9,568,421 B2, DE4306209 A1, DE102013114412 A1 oder US 2017/0323186 A1 sind Verfahren und Vorrichtungen bekannt, um Objekte mit einer individuellen Kennung zu versehen. Originalitätskennzeichnungen und maschinenlesbare Zeichenanordnungen werden auch in den WO 2015/170306 A2 und US 3,636,317 beschrieben.

Ein erfindungsgemäßer CVD-Reaktor besitzt eine Prozesskammer, die von Wänden umgeben ist. Die Wände der Prozesskammer werden von Bauteilen aus hitzebeständigem Material, beispielsweise Keramik, Quarz, Graphit oder Molybdän gebildet. Die Bauteile werden bei der thermischen Behandlung eines Substrates, beispielsweise beim Abscheiden einer Schicht auf einem Substrat aufgeheizt. Zum Abscheiden der Schicht werden Prozessgase in die Prozesskammer eingespeist, die sich dort pyrolytisch zerlegen. Die Zerlegungsprodukte, insbesondere einer metallorganischen Verbindung eines Elementes der III-Hauptgruppe und eines Hydrides eines Elementes der V-Hauptgruppe scheiden sich unter Ausbildung einer Schicht auf der Oberfläche des Substrates ab. Die Qualität der abgeschiedenen Schicht hängt im hohen Maße von dem Erreichen eines gewünschten Temperaturprofils in der Prozesskammer ab. So ist es beispielsweise erforderlich, dass ein lateraler Temperaturgradient auf einem Suszeptor, der die Substrate trägt, möglichst verschwindet. In einigen erfindungsgemäßen Prozesskammern wird der Suszeptor von unten beheizt und eine dem Suszeptor gegenüberliegende Prozesskammerdecke gekühlt. Es sind aber auch andere Anordnungen vorgesehen, bei denen die Prozesskammerdecke ebenfalls beheizt wird. Bestimmte physikalische, insbesondere geometrische Größen des Bauteils, insbesondere des Suszeptors, haben beispielsweise einen großen Einfluss auf Prozessgrößen, wie Temperaturen oder Temperaturprofile in der Prozesskammer. Um den thermischen Behandlungsprozess und insbesondere das Abscheiden einer Schicht mit reproduzierbaren Ergebnissen durchführen zu können, ist es erforderlich, dass die gewünschten Prozessgrö-ßen zuverlässig in einem engen Toleranzbereich gehalten werden. Um die gewünschten Prozessgrößen zu erreichen, werden Aktoren, die beispielsweise wünschten Prozessgrößen zu erreichen, werden Aktoren, die beispielsweise Heizungen oder Massenflusskontroller zum Einstellen von Spülflüssen mittels Prozessparameter eines Rezeptes eingestellt. Die Prozessparameter des Rezeptes können so ausgelegt sein, dass bei Standardwerten der physikalischen Größen der Bauteile die gewünschten Prozessgrößen in der Prozesskammer erreicht werden. Ändern sich die physikalischen Größen, weil beispielsweise ein Bauteil gegen ein anderes Bauteil ausgetauscht worden ist, so ändern sich auch die Prozessgrößen, wenn die Prozessparameter nicht geändert werden. Der Austausch eines Bauteiles kann somit das Temperaturprofil innerhalb der Prozesskammer und damit die Qualität der darin auf Substraten abgeschiedenen Schichten beeinflussen. Als physikalische Größen kommen hier insbesondere toleranzbehaftete Größen in Betracht, wie die mittlere Schichtdicke einer Beschichtung der Oberfläche des Bauteils, der Oberflächenrauhheit, der optischen Emissivität der Oberfläche oder bestimmte Längen-, Breiten- oder Dickenwerte des Bauteils.

Nach dem Austausch eines Bauteils ist es somit oftmals erforderlich, die Prozessparameter des Rezeptes zu modifizieren, um die gewünschten Prozessgrößen innerhalb der Prozesskammer zu erreichen.

### Zusammenfassung der Erfindung

Der Erfindung liegt zunächst die Aufgabe zugrunde, Mittel anzugeben, mit denen die Handhabung einer Vorrichtung zur thermischen Behandlung eines Substrates verbessert wird. Die Erfindung ist in den unabhängigen Ansprüchen definiert.

Zunächst und im Wesentlichen werden die Strukturen vorgeschlagen, mit denen voneinander verschiedene Bereiche, insbesondere Volumenbereiche strukturiert sind. Es handelt sich um solche Strukturen, die Einfluss auf eine lokale Oberflächentemperatur des Bauteiles besitzen und insgesamt eine maschinenlesbare individuelle Kennung ergeben. Die individuelle Kennung ist mit einem Sensor, insbesondere einem Temperatursensor, also beispielsweise einem Infrarotsensor, ermittelbar. Es wird insbesondere ein Pyrometer verwendet, mit dem eine lokale Temperatur auf der Oberfläche des Bauteils, bei dem es sich um einen Suszeptor, ein Seitenteil, eine Decke oder eine Abdeckplatte einer Prozesskammer eines CVD-Reaktors handeln kann, lokal bestimmt werden kann. Entweder durch eine Drehung des Bauteils oder durch ein Wandern des Messpunktes des Sensors über die Oberfläche des Bauteiles kann die individuelle Kennung erfasst werden. Es ist insbesondere vorgesehen, dass der Sensor ein optischer Temperatursensor ist, mit dem eine Steuereinrichtung der Vorrichtung Informationen über die Ist-Temperatur des Bauteiles, insbesondere die Ist-Temperatur eines Suszeptors erhält und wobei diese Temperatur bevorzugt von der Steuereinrichtung zur Regelung der Temperatur des Bauteiles verwendet wird. Bevorzugt wird mit diesem ohnehin vorhandenen, beispielsweise an einem Ende einer Glasfaserleitung, deren anderes Ende auf das Bauteil gerichtet ist, angeordneten optischen Temperatursensor die Kennung gelesen. Hierzu ist es lediglich erforderlich, das Bauteil auf eine Temperatur von beispielsweise über 500°C aufzuheizen, damit die Oberfläche des Bauteils in einem infraroten Frequenzbereich leuchtet, der vom Sensor erfasst werden kann. Die insbesondere benachbart verschiedenen Strukturen können anhand ihrer Strahlungsintensität oder ihres Strahlungsspektrums voneinander unterschieden werden. Bei dem Temperatursensor handelt es sich bevorzugt um einen Infrarotsensor, der eine Infrarot-Optik aufweist, mit der es möglich ist, die Temperatur kleiner Oberflächenbereiche zu ermitteln. Es handelt sich insbesondere um hochortsauflösend messende Sensoren. Die derart anhand ihrer Strahlungsintensität oder ihrer Strahlungsspektren unterscheidbaren Strukturen sind bevorzugt auf einer Rückseite des Bauteiles angeordnet, dessen Vorderseite zur Prozesskammer weist. Gemäß einem Aspekt der Erfindung wird mittels des Temperatursensors eine Oberflächentemperatur der Außenfläche des Bauteiles ermittelt, die zu einer Heizeinrichtung hinweist. Dies kann mit dem oben erwähnten, am Ende einer Glasfaserleitung angeordneten Temperatursensor erfolgen. Das andere Ende der Glasfaserleitung endet mit einem geringen Abstand vor der Außenfläche des Bauteils, dessen Temperatur gemessen werden soll. Gemäß einer Alternative ist vorgesehen, dass die Temperatur an der der Rückseite abgewandten Frontseite des Bauteiles ermittelt wird. Die Frontseite, deren Temperatur vom Temperatursensor gemessen wird, kann glattwandig gestaltet sein oder mit anderen Strukturen versehen werden, beispielsweise mit Vertiefungen oder Rippen zur Lagefixierung der Substrate. Die Volumenbereiche, die mit Strukturen versehen sind, können an ihren Oberflächen Erhebungen oder Vertiefungen aufweisen. Die Volumenbereiche können aber auch Höhlungen aufweisen, mit denen die Volumenbereiche derart strukturiert sind, dass die ihnen zugeordneten, dem IR-Sensor zugewandten Oberflächenbereiche anhand der Höhe des Temperaturmesssignales unterschieden werden können. Die Strukturbereiche können auch Oberflächenbereiche sein. So ist insbesondere vorgesehen, dass sich benachbarte Strukturbereiche der Oberfläche durch die Beschaffenheit der Oberfläche unterscheiden. Die Oberflächenbeschaffenheit kann durch Aufrauhen, Polieren oder durch Aufbringen von Farbpigmenten gestaltet und insbesondere unterschiedlich gestaltet werden. Die Strukturen können entlang einer Kreisbogenlinie eines um das Zentrum der Kreisbogenlinie drehantreibbaren Bauteiles angeordnet sein. Insbesondere handelt es sich bei einem derartigen Bauteil um einen Suszeptor. Auf einer derartigen Anordnung der Strukturen braucht der Messpunkt des Infrarotsensors nicht zu wandern. Die Messstelle kann bezogen auf die Prozesskammer ortsfest verbleiben, da sich das Bauteil unter der Messstelle bewegt. In einer Alternative ist vorgesehen, dass das Bauteil relativ zur Prozesskammer ruht. Hier können die Strukturen in einer geraden Linie hintereinanderliegend angeordnet sein. Es ist aber auch vorgesehen, dass die Strukturen auf einer Fläche angeordnet sind. Das Auslesen der individuellen Kennung, die von den Strukturen gebildet wird, erfolgt dann mit einer sich bewegenden Messstelle. Die Linie beziehungsweise Fläche wird gewissermaßen vom Infrarotsensor wie von einem Barcodeleser gescannt. Die Strukturen, die die individuelle Kennung ergeben, besitzen vorzugsweise voneinander gleich beabstandete Strukturelemente. Die Strukturelemente der Strukturen können in der Art eines Barcodes oder eines QR-Codes angeordnet sein. Die Strukturen beziehungsweise Strukturelemente sind als strukturelle Einheit auf dem Bauteil angeordnet und werden insbesondere von Bereichen mit verschiedenen Materialstärken zwischen einer Vorderseite und einer Rückseite ausgebildet.

Die Erfindung betrifft darüber hinaus ein Verfahren zur Individualisierung eines Bauteils. Jedes einer Vielzahl von ansonsten gleich gestalteten Bauteilen wird mit einer individuellen Kennung versehen. Hierzu werden, wie zuvor beschrieben, Volumenbereiche des Bauteils, die zueinander benachbarten Oberflächenbereichen zugeordnet sind, mit räumlichen Strukturen versehen. Es handelt sich bevorzugt um solche Strukturen, die bei einer Erwärmung des Bauteils im Infrarotbereich voneinander unterscheidbar leuchten. Die Strukturen ergeben insgesamt eine maschinenlesbare individuelle Kennung des Bauteils. Die Kennung kann eine mehrstellige numerische Zeichenfolge sein, im einfachsten Fall handelt es sich um eine Bitfolge, die dadurch gekennzeichnet sein kann, dass der Wert Null keine Vertiefung oder keine Erhebung bedeutet und dass der Wert Eins eine Vertiefung oder eine Erhebung bedeutet. Die Kennung kann aber auch von Erhebungen oder Vertiefungen mit unterschiedlicher Höhe beziehungsweise Tiefe gebildet sein. Neben einer numerischen ist auch eine alphanumerische Zeichenfolge denkbar. Das durch die räumlichen Strukturen erzeugte Wärmebild wird von einem insbesondere örtlich hochauflösenden Temperatursensor erfasst. Das Sensorsignal wird ausgewertet und in die Zeichenfolge gewandelt. Dies erfolgt mit einer Recheneinrichtung. Es kann ferner vorgesehen sein, dass die Zeichenfolge einen kodierten oder verschlüsselten Wert beinhaltet, beispielsweise um eine gewisse Fälschungssicherheit zu erzielen. Der kodierte Wert kann eine Prüfsumme oder ein Hashwert sein. Es ist auch möglich, die Kennung mit einem Schlüssel eines aus einem öffentlichen und einem privaten Schlüssel bestehenden Schlüsselpaar zu verschlüsseln.

In einer Weiterbildung der Erfindung kann in der individuellen Kennung eine Angabe einer insbesondere toleranzbehafteten physikalischen Größe des Bauteils enthalten sein. Die toleranzbehaftete physikalische Größe kann beispielsweise die Dicke einer Beschichtung, Eigenschaften der Oberfläche, beispielsweise Reflektivität oder Emissivität, die Länge, Breite, Dicke des Bauteils oder die Abmessungen einer Oberflächenvertiefung oder eines Oberflächenvorsprungs sein. Diese insbesondere toleranzbehafteten physikalischen Größen werden zunächst an einem noch nicht gekennzeichneten Bauteil bestimmt. Es wird dann unter Verwendung einer Verschlüsselungsfunktion eine individuelle Kennung erzeugt, in der die am Bauteil gemessene physikalische Größe enthalten ist. Die Kennung wird anschließend beispielsweise durch Materialabtrag in der zuvor beschriebenen Weise am Bauteil angebracht, indem beispielsweise Vertiefungen erzeugt werden.

Die Erfindung betrifft darüber hinaus ein Verfahren zur Übermittlung von Informationen an eine Prozesssteuereinrichtung, die anhand von in einem Rezept abgelegten Prozessparametern einen thermischen Behandlungsprozess eines Substrates steuert, indem im Rezept vorgegebene Massenflüsse von Gasen oder Heizungsstellwerte eingestellt werden, beispielsweise indem Regeltemperaturen vorgegeben werden, die an vorgegebenen Messpunkten in der Prozesskammer erreicht werden müssen. Bei dem erfindungsgemäßen Verfahren wird zunächst ein Bauteil bereitgestellt, beispielsweise gefertigt, das eine individuelle Kennung trägt, die optisch, beispielsweise mit einem bilderkennenden Verfahren, beispielsweise mit einer Kamera, aber auch mit einem scannenden Laserstrahl maschinenlesbar ist. Dies kann auch bei Raumtemperatur erfolgen. Bevorzugt ist die Kennung aber so gestaltet, dass sie erst bei der Erwärmung des Bauteiles mit einem Infrarotsensor maschinenlesbar ist. Von diesem Bauteil werden Werte insbesondere toleranzbehafteter physikalischer Grö-ßen bestimmt. Dies kann hier nach dem Anbringen der individuellen Kennung erfolgen. Das Bauteil wird hinsichtlich dieser insbesondere den Prozess beeinflussenden physikalischen Größen vermessen. Diese Messwerte können zusammen mit der Kennung an eine Steuereinrichtung einer Vorrichtung zur thermischen Behandlung eines Substrates übermittelt werden. Es kann vorgesehen sein, dass die Steuereinrichtung ein Rechenprogramm aufweist, welches die Einflüsse der physikalischen Größen auf Prozessparameter ermitteln kann. Es ist insbesondere vorgesehen, dass die Einflüsse ermittelt werden, die die physikalischen Größen auf die Werte von Prozessgrößen besitzen. Dies kann händisch unter Verwendung von Erfahrungen erfolgen. Hierzu können aber auch Modellrechnungen durchgeführt werden. Es ist auch vorgesehen, dass Versuche gemacht werden, bei denen das Bauteil unter Prozessbedingungen aufgeheizt wird und ein Temperaturprofil innerhalb der Prozesskammer aufgenommen wird. Es werden dann ebenfalls entweder anhand von Modelrechnungen oder aber auch experimentell Korrekturwerte ermittelt, mit denen die Prozessparameter, also die Werte zur Steuerung der Heizleistung oder der Massenflüsse von Gasen derart korrigiert werden, dass die gewünschten Prozessgrößen, also insbesondere Temperaturen innerhalb der Prozesskammer erreicht werden können. Diese Korrekturwerte können verwendet werden, wenn die Vorrichtung mit dem die individuelle Kennung tragenden Bauteil verwendet wird. Es ist aber auch vorgesehen, diese Korrekturwerte logisch der jeweiligen individuellen Kennung des Bauteiles zuzuordnen. Dies erfolgt bevorzugt dann, wenn die Modellrechnungen nicht von der Prozesssteuereinrichtung selbst durchgeführt worden sind, sondern durch eine andere Recheneinrichtung. Hierzu kann beispielsweise eine Datei erzeugt werden, die neben den Korrekturwerten auch die individuelle Kennung enthält oder deren Dateiname die individuelle Kennung ist. Es ist aber auch vorgesehen, dass die Korrekturwerte und die individuelle Kennung in einer zentralen oder dezentralen Datenbank miteinander logisch verknüpft sind. Zusammen mit der Kennung werden die Korrekturwerte der Prozesssteuereinrichtung übermittelt. Dies kann durch Übermitteln eines Links auf eine Datei, durch die Ermöglichung eines Zugriffs auf eine lokale oder zentrale Datenbank oder über traditionelle Kommunikationskanäle, wie Brief oder Telefon, erfolgen. Bei einem erfindungsgemäßen Verfahren zur Korrektur von Prozessparametern eines Rezeptes werden die derart an die Prozesssteuereinrichtung übermittelten Korrekturwerte verwendet, um die in einem Rezept hinterlegten Prozessparameter zu modifizieren. Das Verfahren wird insbesondere angewendet, wenn ein Bauteil aus einem CVD-Reaktor entfernt wird und gegen ein anderes Bauteil ausgetauscht wird. Die Prozesskammer und insbesondere das Bauteil werden auf eine Temperatur aufgeheizt, bei der mit Hilfe des ohnehin in der Prozesskammer vorhandenen Infrarotsensors die Kennung ermittelbar ist. Die bei der Zieltemperatur im Infrarotbereich leuchtende Kennung wird mittels des Infrarotsensors bestimmt. Anhand der logischen Zuordnung von Korrekturwerten zu der individuellen Kennung kann dann das Rezept modifiziert werden, indem ausgewählte Prozessparameter anhand der Korrekturwerte modifiziert werden.

Es kann ferner vorgesehen sein, dass mit Hilfe des Infrarotsensors oder mit Hilfe anderer in der Vorrichtung angeordneter Sensoren oder Messelemente zumindest eine physikalische Größe des in der Prozesskammer angeordneten Bauteiles ermittelt wird. Die von dem Bauteil gemessene individuelle Kennung wird dann entschlüsselt. Aus den entschlüsselten Werten kann die physikalische Größe ausgelesen werden. Diese kann mit der in situ gemessenen physikalischen Größe verglichen werden. Bei einer Übereinstimmung kann das Bauteil als Originalteil angesehen werden. Liegt der in situ gemessene Wert der physikalischen Größe außerhalb eines Bereichs um den Wert, der aus der individuellen Kennung gewonnen wurde, so kann das Bauteil als nicht Originalteil angesehen werden.

Ein weiterer Aspekt der Erfindung betrifft die Freischaltung von Funktionen der Steuereinrichtung. So kann beispielsweise vorgesehen sein, dass bestimmte Funktionen der Steuereinrichtung nur dann verwendbar sind, wenn die individuelle Kennung des Bauteils, die bevorzugt innerhalb der Vorrichtung bei geschlossener Vorrichtung ermittelt wird, einer Gruppe von zulässigen individuellen Kennungen zugehörig ist. Dies ist insbesondere vorgesehen, wenn das Programm zur Durchführung des Verfahrens auf der Vorrichtung ein Update erhält.

### Kurze Beschreibung der Zeichnungen

Ausführungsbeispiele der Erfindung werden nachfolgend anhand beigefügter Zeichnungen erläutert. Es zeigen:
- Fig. 1: schematisch einen Querschnitt durch einen CVD-Reaktor 1 und einer darin angeordneten Prozesskammer 2 sowie mit einer Prozesssteuereinrichtung 15,
- Fig. 2: schematisch den Schnitt gemäß der Linie II-II in Figur 1, der einer Draufsicht auf den Suszeptor 10 entspricht,
- Fig. 3: den Schnitt gemäß der Linie III-III in Figur 1, entsprechend einer Unteransicht des Suszeptors 10,
- Fig. 4: den Schnitt entlang der Schnittlinie IV-IV in Figur 3 zur Verdeutlichung von Strukturen 7, 8 am Suszeptor 10, die hier zur Verdeutlichung übertrieben stark dargestellt sind,
- Fig. 5: eine Draufsicht auf eines der Bauteile 10, 11, 12, 13 mit einer entlang einer geraden Linie angeordneten, von Vertiefungen 8 und Erhebungen 7 ausgebildeten individuellen Kennung 16,
- Fig. 6: eine individuelle Kennung 16 in Form von auf einer Fläche angeordneten Vertiefungen 8,
- Fig. 7: eine individuelle Kennung 16 in Form von Höhlungen 9, 9' innerhalb des Volumens eines Bauteiles 10, 11, 12, 13,
- Fig. 8: schematisch die Ermittlung einer individuellen Kennung unter Verwendung eines Rechners einer Prozesssteuereinrichtung 15, eines Infrarotsensors 14 und einer Heizung 5,
- Fig. 9: eine Darstellung gemäß Figur 1 eines weiteren Ausführungsbeispiels, bei dem die Temperatur eines Suszeptors 10 an dessen Unterseite mittels einer Glasfaserleitung 21 gemessen wird.

### Beschreibung der Ausführungsformen

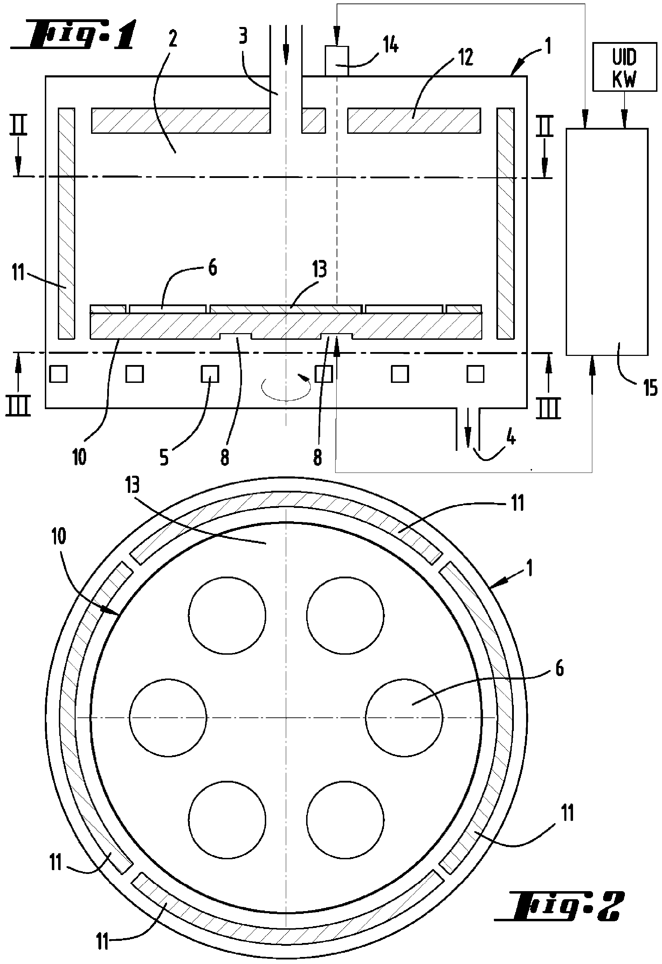

Der in der Figur 1 schematisch dargestellte CVD-Reaktor 1 besitzt ein gasdichtes Gehäuse, in dem sich eine Prozesskammer 2 befindet. Die Prozesskammer 2 besitzt einen Suszeptor 10, der von einem Graphitteil, Molybdänteil, Quarzteil oder Keramikteil gebildet sein kann. Unterhalb des Suszeptors 10 befindet sich eine Heizung 5 zum Aufheizen des Suszeptors 10 auf Temperaturen oberhalb von 500 oder oberhalb von 700°C.

Auf der zu einer Prozesskammerdecke 12 weisenden Oberseite des Suszeptors 10 befindet sich eine Abdeckplatte 13, die auch aus mehreren Teilstücken bestehen kann. Die Abdeckplatte 13 besitzt kreisförmige Öffnungen, in denen Substrate 6 angeordnet sind, die in der Prozesskammer 2 mit einer Schicht beschichtet werden sollen.

Die Prozesskammerdecke 12 und Seitenteile 11, die die Prozesskammer 2 umgeben, sind ebenfalls aus Graphit, Molybdän, Quarz oder Keramik gefertigt.

Zum Abscheiden einer Schicht auf den Substraten 6 wird mit Hilfe eines Gaseinlasses 3 ein Prozessgas, das aus mehreren Gasen bestehen kann, in die Prozesskammer 2 eingespeist. Die Bestandteile der Gase zerlegen sich in der Prozesskammer 2, so dass auf den Substraten 6 eine Schicht abgeschieden wird. Reaktionsprodukte beziehungsweise ein Trägergas, das ebenfalls durch den Gaseinlass 3 eingespeist wird, können den CVD-Reaktor 1 durch einen Gasauslass 4 wieder verlassen. An den Gasauslass 4 kann sich eine Vakuumpumpe anschließen. Als Prozessgase werden insbesondere metallorganische Verbindungen der III-Hauptgruppe und Hydride der V-Hauptgruppe verwendet, die zusammen mit einem Trägergas, beispielsweise Wasserstoff, mittels eines in den Zeichnungen nicht dargestellten, aus anderweitigem Stand der Technik aber bekannten Gaseinlassorgans in die Prozesskammer 2 eingespeist werden.

Mit einer Heizung 5, bei der es sich um eine Infrarotheizung oder um eine RF-Heizung handeln kann, wird der Suszeptor 10 von unten beheizt. Einhergehend damit werden auch die Seitenteile 11 und die Prozesskammerdecke 12 auf eine erhöhte Temperatur aufgeheizt.

Mit einem Infrarotsensor 14, beispielsweise einem Pyrometer, kann in bekannter Weise die Oberflächentemperatur einer Abdeckplatte 13 oder des unterhalb der Abdeckplatte 13 liegenden Suszeptors 10 gemessen werden. Es sind weitere, in der Figur 1 nicht dargestellte IR-Sensoren 14 vorgesehen, mit denen die Oberflächentemperaturen der Seitenteile 11, der Decke 12, der Abdeckplatte 13 oder des Suszeptors 10 ermittelt werden können. Der Suszeptor 10, die Seitenteile 11, die Decke 12 und die Abdeckplatte 13 bilden insgesamt Bauteile, deren Oberfläche bei einer Erwärmung im Infrarotbereich leuchtet. Die Temperaturen auf der Rückseite und der Vorderseite können voneinander verschieden sein, so dass Wärme durch das Bauteil fließt.

Erfindungsgemäß ist vorgesehen, dass zumindest eines der Bauteile 10, 11, 12, 13, bevorzugt der Suszeptor 10, mit einer individuellen Kennung 16 versehen wird, wobei die individuelle Kennung bevorzugt Volumenbereichen zugeordnet ist, durch die aufgrund eines Temperaturgradienten Wärme fließt. Aufgrund voneinander verschiedenen wirksamen Materialstärken des Bauteils 10,11,12,13 stellen sich auf der von der Wärmequelle wegweisenden Oberfläche lokal unterschiedliche Oberflächentemperaturen ein.

Der Suszeptor 10, der um eine Drehachse drehbar ist, besitzt eine sich auf einer Kreisbogenlinie um das Drehzentrum des Suszeptors 10 erstreckende Kennung 16. Die Kennung 16 kann aus auf der Kreisbogenlinie angeordneten Erhebungen 7, die voneinander beabstandet sind, und/oder von Vertiefungen 8, die voneinander beabstandet sind, gebildet sein. Die Erhebungen 7 beziehungsweise Vertiefungen 8 können in Richtung des Bogens der Kreisbogenlinie eine unterschiedliche Weite aufweisen. Diese Vertiefungen 8 beziehungsweise Erhebungen 7 beeinflussen die wirksame Materialstärke des Bauteils.

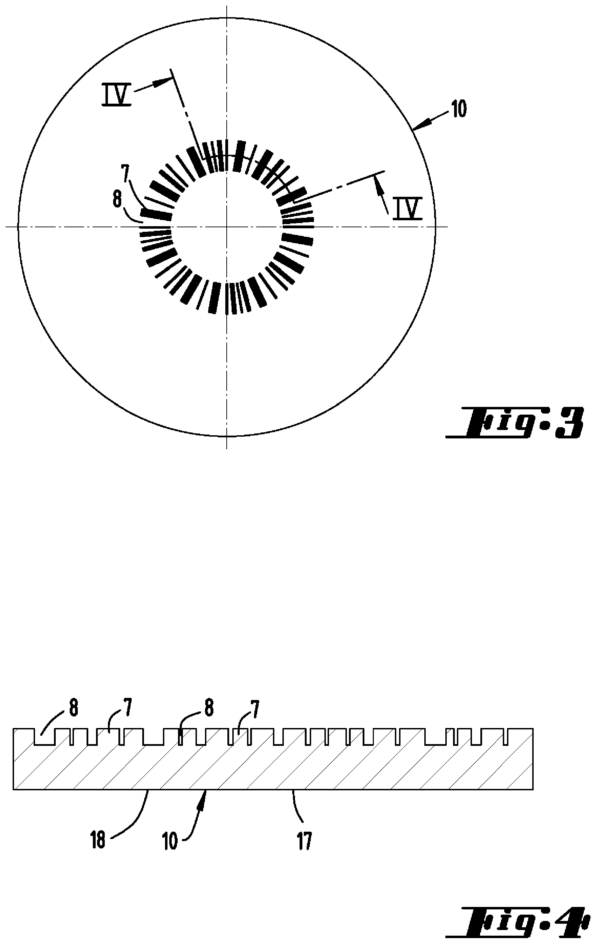

Wie die Figur 4 zeigt, sind die von den Erhebungen und den Vertiefungen 8 ausgebildeten Strukturen auf der zur Heizung 5 hin gewandten Rückseite angeordnet. Die Erhebungen 7 und die Vertiefungen 8 beeinflussen den Wärmetransport durch den Suszeptor 10 derart, dass in Oberflächenbereichen 17, die den Erhebungen 7 gegenüberliegen, und in Oberflächenbereichen 18, die den Vertiefungen 8 gegenüberliegen, voneinander verschiedene Temperaturen gemessen werden. Erfolgt der Wärmetransport von der Heizung zur Unterseite des Suszeptors 10 im Wesentlichen durch Wärmestrahlung, so ist die Wärmetransportstrecke im Bereich der Vertiefung 8 zum gegenüberliegenden Oberflächenbereich 18 kleiner als die Wärmetransportstrecke im Bereich einer Erhebung 7 zum gegenüberliegenden Oberflächenbereich 17. Dies hat zur Folge, dass die Oberflächentemperatur im Oberflächenbereich 18 geringfügig höher ist, als im Oberflächenbereich 17.

Mit dem Infrarotsensor 14, der insbesondere eine Optik aufweist, kann die Temperatur an einem räumlich eng begrenzten Messpunkt gemessen werden. Wird der Suszeptor 10 jetzt um seine Drehachse drehangetrieben, so wandert der Messpunkt des Infrarotsensors 14 entlang einer Kreisbogenlinie über die Oberseite des Suszeptors 10, der auf eben dieser Kreisbogenlinie auf der Unterseite die Strukturen 7, 8 aufweist. Es ergibt sich ein zeitabhängiges Temperatursensorsignal, aus dem ein Rechtecksignal gebildet werden kann. Dieses Rechtecksignal repräsentiert Pulsfolgen. Aus der Länge der Pulse der Pulsfolgen kann ein Bitsignal gewonnen werden. Das Bitsignal repräsentiert eine individuelle Kennung 16 des Bauteils 10.

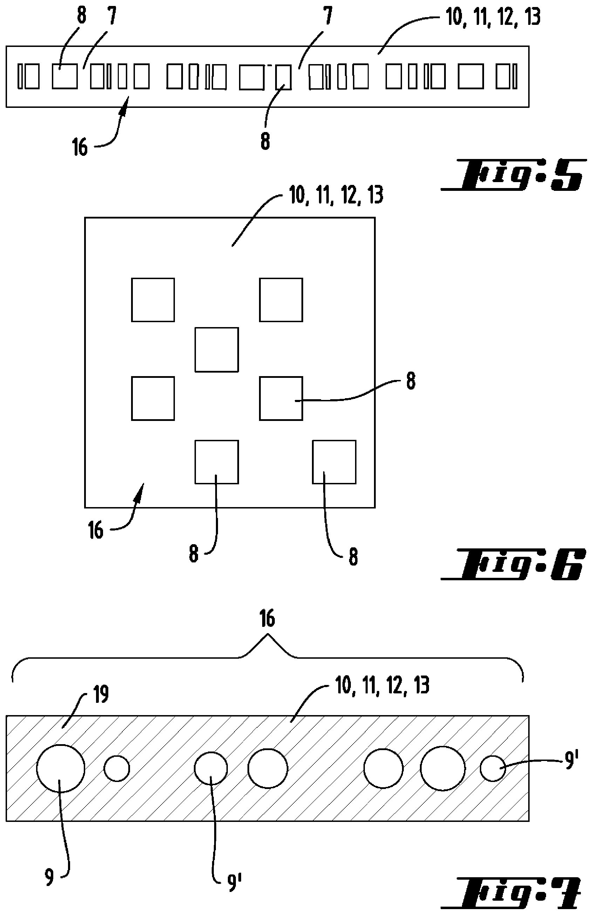

Bei dem in der Figur 5 dargestellten Ausführungsbeispiel ist eine Vielzahl von Vertiefungen 8 in einer geraden Linie hintereinanderliegend angeordnet. Die hintereinander angeordneten Strukturen können aber auch von auf einer Linie angeordneten Erhebungen 7 ausgebildet werden. Zur Ermittlung der von den Erhebungen 7 beziehungsweise Vertiefungen 8 gebildeten individuellen Kennung 16 kann eine Messstelle des IR-Sensors 14, beispielsweise unter Verwendung geeigneter Spiegel, über die Oberfläche des Bauteils 10, 11, 12, 13 wandern.

Bei dem in der Figur 6 dargestellten Ausführungsbeispiel sind die Strukturen, insbesondere die Vertiefungen 8 auf einer Fläche angeordnet. Hier kann der Messpunkt scannend über die Fläche verlagert werden, um die individuelle Kennung auszulesen. Die Strukturen sind hier in der Art eines QR-Codes angeordnet und können auch in derselben Weise kodiert sein, so dass die Strukturen mit einem QR-Code-Scanverfahren ausgelesen werden können.

Bei dem in der Figur 3 dargestellten Ausführungsbeispiel und weiteren, nicht dargestellten Ausführungsbeispielen, sind die Strukturen in der Art eines Barcodes angeordnet und können mit einem Barcode-Ausleseverfahren erkannt werden.

Bei dem in der Figur 7 dargestellten Ausführungsbeispiel wird die Kennung 16 durch Höhlungen 9, 9' innerhalb des Bauteils 10, 11, 12, 13 erreicht. Bei den Höhlungen 9, 9' kann es sich um Bohrungen handeln, die von der Schmalseite her um das Bauteil 10, 11, 12, 13 eingebracht worden sind. Die Höhlungen 9, 9' können Bohrungen mit voneinander verschiedenen Durchmessern sein. Die Bohrungen sind auch in voneinander verschiedenen Abständen angeordnet. Es ist insbesondere vorgesehen, dass gleich große, aneinander angrenzende Oberflächenbereiche dadurch strukturiert sind, dass sie entweder eine Bohrung mit einem großen Durchmesser, eine Bohrung mit einem kleinen Durchmesser oder überhaupt keine Bohrung aufweisen. Die Bohrungen 9, 9' beeinflussen ebenso wie die Erhebungen 7 und die Vertiefungen 8 den Wärmetransport von einer Breitseite des Bauteils zur gegenüberliegenden Breitseite des Bauteils, so dass die Oberflächentemperaturen in aneinander angrenzenden Oberflächenbereichen 17, 18, 19 sich mit einem Infrarotsensor, insbesondere Pyrometer, messbar unterscheiden.

Bei der Kennung 16 kann es sich um eine bei der Formgebung des Bauteils 10, 11, 12, 13 durch Spanabheben erzeugte Strukturenfolge handeln. Das Bauteil 10 bis 13 kann nach dem Anbringen der Strukturen 7 bis 9 beschichtet werden. Es ist aber auch vorgesehen, dass die Strukturen 7, 8, 9 erst nach einer ansonsten vollständigen Fertigung des Bauteils 10 bis 13 angebracht werden. Bei dieser Variante werden vor dem Anbringen der Kennung 16 physikalische Größen des Bauteils 10 bis 13, beispielsweise Längenmaße, Breitenmaße, Dickenmaße oder Maße von Oberflächenstrukturen ermittelt. Es ist auch vorgesehen, dass die Materialstärke einer Beschichtung, mit der das Bauteil 10 bis 13 beschichtet ist, als physikalische Größe verwendet wird.

Bei einer Variante der Erfindung wird zumindest aus einem Wert einer derartigen physikalischen Größe eine Kennung 16 ermittelt. Diese wird dann in verschlüsselter Form als Bitfolge in Form von Erhebungen 7 oder Vertiefungen 8 oder Höhlungen 9 am Bauteil 10 bis 13 angebracht. Wird die Kennung 16 dann anschließend gelesen, kann daraus durch eine Entschlüsselung der Wert der physikalischen Größe rekonstruiert werden. Er kann mit der tatsächlichen physikalischen Größe, die dann erneut gemessen wird, verglichen werden. Auf diese Weise ist die Erkennung eines Originalteiles möglich.

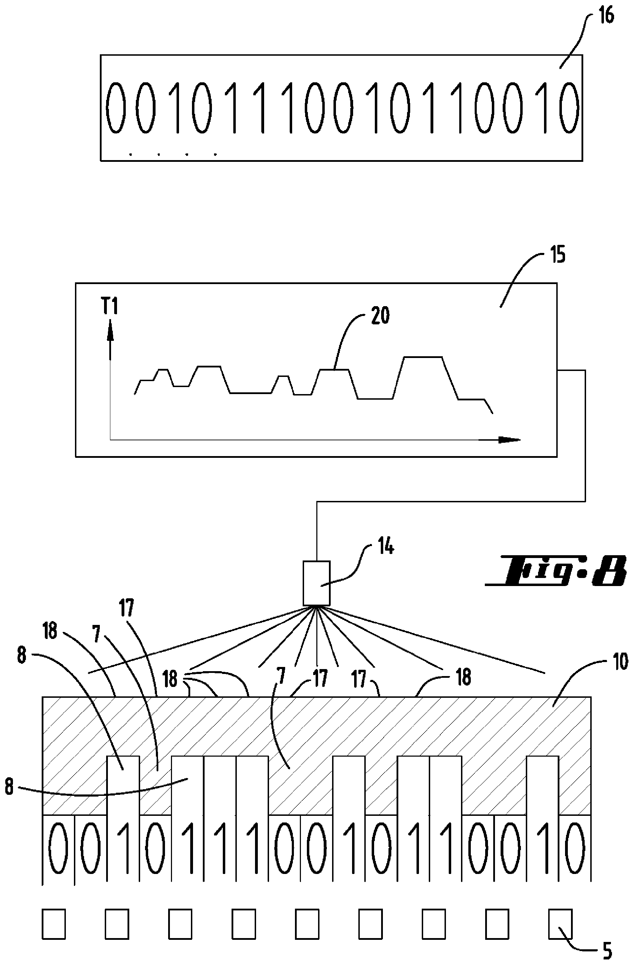

Die Figur 8 zeigt schematisch, wie mittels eines IR-Sensors 14 die auf der Rückseite eines Suszeptors 10 angeordnete Kennung optisch gelesen werden kann.

Der Suszeptor 10 wird von unten mit einer Heizung 5 beheizt. Auf der Unterseite befinden sich nebeneinander benachbarte Erhebungen 7 und Vertiefungen 8. Die den Erhebungen 7 gegenüberliegenden Oberflächenabschnitte 17 besitzen eine geringere Oberflächentemperatur als die Oberflächenabschnitte 18 der Oberseite, die den Vertiefungen 8 gegenüberliegen. Mit dem IR-Sensor 14 kann gewissermaßen ein Temperaturscan der von der Heizung 5 wegweisenden Oberseite des Suszeptors 10 hergestellt werden. Es ergibt sich dann der ebenfalls in der Figur 8 schematisch dargestellte Temperaturverlauf 20, der ein Sensorsignal symbolisiert. Mit der Prozesssteuerung 15 oder einem anderen Rechner kann daraus dann die Kennung 16 ermittelt werden, wobei jeder Erhebung der Binärwert Null und jeder Vertiefung 8 der Binärwert Eins zugeordnet ist. Die Vertiefungen 8 beziehungsweise Erhebungen 7 sind auch hier zwecks Verdeutlichung übertrieben stark ausgeprägt dargestellt.

Gemäß einer Variante der Erfindung ist vorgesehen, dass nach der Fertigung eines Bauteils 10, 11, 12, 13 dessen relevante physikalische Größen bestimmt werden. Das Bauteil wird optisch oder anderweitig vermessen. Es werden die Längen, Breiten und Dicken oder Maße anderer Strukturen des Bauteiles ermittelt. Ferner werden die Dicke sowie optische Eigenschaften einer Beschichtung ermittelt. Dies kann entweder vor dem Anbringen der die Kennung 16 bildenden Strukturen 7, 8, 9 oder danach erfolgen. Die ermittelten physikalischen Größen werden in einer Datei elektronisch auf einem Datenträger oder auf einem Messblatt gespeichert. Die Datei wird mit der individuellen Kennung gekennzeichnet. Auch das Messblatt kann mit der individuellen Kennung gekennzeichnet werden.

Es ist dann möglich, das Bauteil, welches in einer Fertigung beispielsweise gegen ein Ersatzteil ausgetauscht worden ist, in situ in der Prozesskammer 2 zu erkennen, da die Kennung 16 mittels eines IR-Sensors 14 ermittelbar ist, wenn das Bauteil 10 bis 13 aufgeheizt ist beziehungsweise wenn sich im Bauteil 10 bis 13 ein Temperaturgradient zwischen den beiden Breitseiten ausbildet. Es ist somit möglich, während des Betriebes zu ermitteln, um welches Bauteil 10 bis 13 es sich handelt, um dann anhand der zuvor ermittelten Daten der physikalischen Größen eventuell korrigierend in den Prozess einzugreifen, indem Prozessparameter modifiziert werden.

In einer Variante der Erfindung ist vorgesehen, dass nach der Fertigung des Bauteiles 10 bis 13 anhand von Modellrechnungen oder im Wege von Experimenten ermittelt wird, welche Einflüsse die insbesondere einer Toleranz unterliegenden physikalischen Größen auf Prozessgrößen besitzen. Als Prozessgröße kommt hier insbesondere eine oder mehrere Temperaturen in Betracht, insbesondere ein Temperaturprofil innerhalb der Prozesskammer 2 oder ein lateraler Temperaturgradient auf der Oberseite des Suszeptors 10 oder eines anderen Bauteils. Es kann dann ermittelt werden, inwieweit die Prozessparameter, also beispielsweise die Steuerung einer Heizung, insbesondere deren Soll- oder Zieltemperatur modifiziert werden muss, um die Prozessgröße auf den Sollwert zu bringen. Hierbei werden Korrekturwerte erzeugt. Diese können an die Prozesssteuerung 15 einer Fertigungsvorrichtung übermittelt werden. Die Fertigungsvorrichtung ist in der Lage, selbständig die Kennung der in der Prozesskammer 2 verbauten Bauteile 10 bis 13 zu ermitteln und anschließend durch Anwendung der Korrekturwerte die Prozessparameter des Rezeptes zu modifizieren, so dass auch mit dem ausgetauschten Ersatzteil, welches sich vom zuvor verbauten Teil unterscheidet, dieselben Prozessergebnisse zu erzielen.

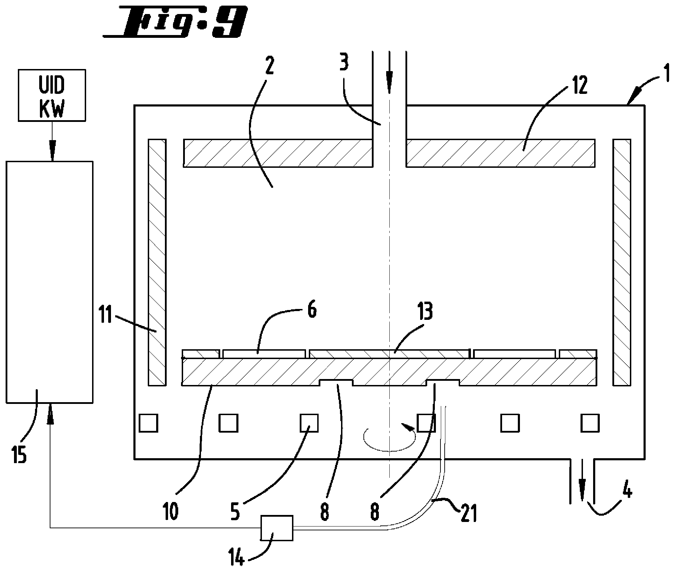

Die Figur 9 zeigt eine Darstellung gemäß Figur 1. Während bei dem in Figur 1 dargestellten Ausführungsbeispiel die Temperatur eines Suszeptors 10 an dessen Oberseite, also an dessen von der Heizung 5 wegweisenden Seite, gemessen wird, besitzt das in der Figur 9 dargestellte Ausführungsbeispiel einen Lichtleiter 21, der mit einem Ende mit einem optischen Sensor 14 verbunden ist, bei dem es sich um einen IR-Sensor handelt. Das andere Ende des Lichtleiters 21 endet mit einem geringen Abstand vor der der Heizung 5 zugewandten Seite des Suszeptors 10. Diese Seite trägt die Vertiefungen 8, die insgesamt eine maschinenlesbare Kennung ergeben. Auf der von der Heizung 5 wegweisenden Seite trägt der Suszeptor 10 eine Abdeckplatte 13 mit Öffnungen, in denen sich Substrate 6 befinden.

Die vorstehenden Ausführungen dienen der Erläuterung der von der Anmeldung insgesamt erfassten Erfindungen, die den Stand der Technik zumindest durch die folgenden Merkmalskombinationen jeweils auch eigenständig weiterbilden, wobei zwei, mehrere oder alle dieser Merkmalskombinationen auch kombiniert sein können.

## Patentansprüche

1. Verfahren zur Individualisierung eines Bauteiles (10, 11, 12, 13), wobei einander benachbarte Bereiche (17, 18, 19) des Bauteils (10, 11, 12, 13) zugeordnete Volumenbereiche des Bauteils (10, 11, 12, 13) mit räumlichen Strukturen (7, 8, 9) versehen werden, die optisch voneinander unterscheidbar sind und insgesamt als einheitliche, zusammenhängende Strukturanordnung eine von einem Sensor (14) maschinenlesbare individuelle Kennung (16) bilden, **dadurch gekennzeichnet, dass** das Bauteil Bestandteil einer Vorrichtung zum thermischen Behandeln eines Substrates ist und die Kennung mit einem Temperatursensor ermittelt wird.

2. Verfahren nach Anspruch 1, **dadurch gekennzeichnet, dass** die Strukturen von in einer Außenfläche des Bauteiles (10, 11, 12, 13) angeordneten Erhebungen (7) oder Vertiefungen (8), von der Beschaffenheit der Oberfläche der Au-ßenfläche und/oder von im Volumen angeordneten Höhlungen (9) gebildet sind.

3. Verfahren nach einem der Ansprüche 1 oder 2, **dadurch gekennzeichnet, dass** die Kennung (16) durch Auswerten des Sensorsignales eines IR-Sensors (14) in eine mehrstellige numerische oder alphanumerische Zeichenfolge gewandelt wird, wobei die Zeichenfolge insbesondere kodierte Werte beinhaltet.

4. Verfahren nach einem der Ansprüche 1 bis 3, **dadurch gekennzeichnet, dass** die individuelle Kennung (16) einen Wert einer insbesondere toleranzbehafteten physikalischen Größe beinhaltet, welche Größe am Bauteil (10, 11, 12, 13) messbar ist.

5. Verfahren nach einem der Ansprüche 1 bis 4, **dadurch gekennzeichnet, dass** mit dem Erfassen der individuellen Kennung (16) eine Freischaltfunktion ausgelöst wird.

6. Verfahren nach Anspruch 4, aufweisend folgende weitere Verfahrensschritte:
- Bestimmen der insbesondere toleranzbehafteten physikalischen Größen des Bauteils (10, 11, 12, 13) und/oder Ermitteln der Einflüsse der physikalischen Größe auf die Werte von Prozessgrößen bei der thermischen Behandlung eines Substrates und von Korrekturwerten zur Korrektur von Prozessparametern;
- Zuordnen der Korrekturwerte und/oder der physikalischen Größen zu der individuellen Kennung (16);
- Übermitteln der individuellen Kennung (16) und der physikalischen Grö-ßen und/oder der Korrekturwerte an die Prozesssteuereinrichtung (15).

7. Verfahren nach Anspruch 6, aufweisend die folgenden weiteren Verfahrensschritte:
- Einbauen des Bauteils (10,11,12,13), das die individuelle Kennung (16) trägt, in die Vorrichtung;
- Schließen der Vorrichtung (1);
- Ermitteln der individuellen Kennung (16) des in der Vorrichtung eingebauten Bauteils (10,11,12,13);
- Korrigieren der Prozessparameter unter Verwendung der übermittelten physikalischen Größen und/oder der Korrekturwerte.

8. Bauteil (10,11,12,13) zur Durchführung des Verfahrens nach einem der Ansprüche 1 bis 7, wobei das Bauteil (10, 11, 12, 13) Bereiche aufweist, die mit Strukturen (7, 8, 9) strukturiert sind, die von einer Außenfläche des Bauteiles (10, 11, 12, 13) angeordneten Erhebungen (7) oder Vertiefungen (8), von der Beschaffenheit der Oberfläche der Außenfläche gebildet sind, die optisch voneinander unterscheidbar sind und insgesamt als einheitliche, zusammenhängende Strukturanordnung eine von einem Sensor (14) maschinenlesbare individuelle Kennung (16) bilden, **dadurch gekennzeichnet, dass** die Strukturen (7, 8, 9) derart ausgebildet sind, dass die Struktur (7, 8, 9) bei der thermischen Behandlung einhergehend mit einem Aufheizen des Bauteils (10,11,12,13) mit einer Heizeinrichtung (5) auf eine Temperatur mit einem Temperatursensor (14) anhand der Höhe des Sensorsignales (20) des Temperatursensors (14) voneinander unterscheidbar sind und die Kennung (16) ermittelbar ist, wobei die Materialstärke und die Wärmeleitfähigkeit des Bauteils (10, 11, 12, 13) derart gewählt ist, dass die auf einer ersten Außenfläche des Bauteils (10, 11, 12, 13) angeordneten Strukturen vom Sensor (14) auf einer von der ersten Außenfläche wegweisenden zweiten Außenfläche erkennbar sind.

9. Bauteil nach Anspruch 8 oder Verfahren nach einem der Ansprüche 1 bis 7, **dadurch gekennzeichnet, dass** das Bauteil (10, 11, 12, 13) der Vorrichtung (1) ein Suszeptor (10) ein Seitenteil (11), eine Decke (12), eine Abdeckplatte (13) oder ein anderes Bauteil einer CVD-Prozesskammer (2) ist.

10. Bauteil nach einem der Ansprüche 8 oder 9 oder Verfahren nach einem der Ansprüche 1 bis 7, **dadurch gekennzeichnet, dass** die Strukturen (7, 8, 9) entlang einer Kreisbogenlinie eines um das Zentrum der Kreisbogenlinie drehantreibbaren Bauteils (10) angeordnet sind oder dass die Strukturen (7, 8, 9) entlang einer Geraden angeordnet sind.

11. Bauteil nach einem der Ansprüche 8 bis 10, **dadurch gekennzeichnet, dass** die Bereiche durch Aufrauhen, Polieren oder aufgebrachte Pigmente strukturierte Oberflächenbereiche sind.

12. Bauteil nach einem der Ansprüche 8 bis 11, **dadurch gekennzeichnet, dass** die Bereiche bei Erwärmung des Bauteils (10,11,12,13) insbesondere bei einem Wärmefluss durch das Bauteil (10, 11, 12, 13) im Infrarotbereich leuchten.

13. Vorrichtung (1) zur thermischen Behandlung zumindest eines Substrates (6) mit zumindest einer Steuereinrichtung (15), die zur Durchführung eines Verfahrens gemäß einem der Ansprüche 1 bis 8 eingerichtet ist, einem Bauteil (10, 11, 12, 13), einem Temperatursensor (14) und einer Heizeinrichtung (5), wobei das Bauteil (10,11,12,13) bei der thermischen Behandlung mit der Heizeinrichtung (5) auf eine Temperatur aufheizbar ist, bei der mit dem Temperatursensor (14) Oberflächenbereiche (17, 18, 19) voneinander verschiedener strukturierter Bereiche des Bauteiles (10, 11, 12, 13) anhand der Höhe des Sensorsignales (20) voneinander unterscheidbar sind, **gekennzeichnet durch** ein Bauteil (10, 11, 12, 13) gemäß einem der Ansprüche 9 bis 12.

14. Vorrichtung nach Anspruch 13, **dadurch gekennzeichnet, dass** der Temperatursensor (14) ein Sensor zur Regelung der Temperatur des Bauteils ist und die Steuereinrichtung (15) so eingerichtet ist, dass aus zeitlichen Schwankungen des Sensorsignals die Kennung ermittelbar ist beziehungsweise ermittelt wird.

## Claims

1. Method for individualizing a component (10, 11, 12, 13), wherein adjacent regions (17,18,19) of the component (10, 11, 12, 13) and associated volume regions of the component (10, 11, 12, 13) are provided with spatial structures (7, 8, 9), which are optically distinguishable from one another and altogether form a uniform, coherent structural arrangement, of an individual identification (16) which can be machine-read by a sensor (14), **characterized in that** the component is part of an apparatus for thermal treatment of a substrate and the identification is determined by a temperature sensor.

2. Method according to claim 1, **characterized in that** the structures are formed by elevations (7) or depressions (8) arranged in an outer surface of the component (10, 11, 12, 13), by the nature of the surface of the outer surface and/or by cavities (9) arranged in the volume.

3. Method according to one of claims 1 or 2, **characterized in that** the identifier (16) is converted into a multi-digit numeric or alphanumeric character string by evaluating the sensor signal of an IR sensor (14), the character string containing, in particular, coded values.

4. Method according to one of claims 1 to 3, **characterized in that** the individual identifier (16) contains a value of a physical quantity, in particular one subject to tolerances, which quantity can be measured on the component (10, 11, 12, 13).

5. Method according to one of claims 1 to 4, **characterized in that** the detection of the individual identifier (16) triggers a release function.

6. Method according to claim 4, comprising the following further method steps:
- Determining the physical variables of the component (10, 11, 12, 13), in particular those subject to tolerances, and/or determining the influences of the physical variables on the values of process variables during the thermal treatment of a substrate and correction values for correcting process parameters;
- Assigning the correction values and/or the physical quantities to the individual identifier (16);
- transmitting the individual identifier (16) and the physical quantities and/or the correction values to the process control device (15).

7. Method according to claim 6, comprising the following further method steps:
- Installing the component (10, 11, 12, 13) bearing the individual identifier (16) in the device;
- closing the device (1);
- Determining the individual identification (16) of the component (10, 11, 12, 13) installed in the device;
- correcting the process parameters using the transmitted physical quantities and/or the correction values.

8. Component (10, 11, 12, 13) for carrying out the method according to one of claims 1 to 7, wherein the component (10, 11, 12, 13) has regions which are structured with structures (7, 8, 9) which are formed by elevations (7) or depressions (8) arranged on an outer surface of the component (10, 11, 12, 13), which are optically distinguishable from one another and altogether form a uniform, coherent structural arrangement of an individual identification (16) which can be machine-read by a sensor (14), **characterized in that** the structures (7, 8, 9) are designed in such a way that the structures (7, 8, 9) can be distinguished from one another and the identification (16) can be determined, by means of the height of the sensor signal (20) of the temperature sensor (14) during thermal treatment accompanied by heating of the component (10, 11, 12, 13) with a heating device (5) to a temperature, the material thickness and the thermal conductivity of the component (10, 11, 12, 13) being selected in such a way that the structures arranged on a first outer surface of the component (10, 11, 12, 13) can be recognized by the sensor (14) on a second outer surface facing away from the first outer surface.

9. Component according to claim 8 or method according to any one of claims 1 to 7, **characterized in that** the component (10, 11, 12, 13) of the device (1) is a susceptor (10) a side part (11), a ceiling (12), a cover plate (13) or another component of a CVD process chamber (2).

10. Component according to one of claims 8 or 9 or method according to one of claims 1 to 7, **characterized in that** the structures (7, 8, 9) are arranged along a circular arc line of a component (10) which can be driven in rotation about the center of the circular arc line, or **in that** the structures (7, 8, 9) are arranged along a straight line.

11. Component according to one of claims 8 to 10, **characterized in that** the areas are surface areas structured by roughening, polishing or applied pigments.

12. Component according to any one of claims 8 to 11, **characterized in that** the areas illuminate when the component (10, 11, 12, 13) is heated, in particular when heat flows through the component (10, 11, 12, 13) in the infrared range.

13. Device (1) for the thermal treatment of at least one substrate (6), having at least one control device (15) which is set up to carry out a method according to one of claims 1 to 8, a component (10, 11, 12, 13), a temperature sensor (14) and a heating device (5), it being possible to heat the component (10, 11, 12, 13) can be heated during the thermal treatment with the heating device (5) to a temperature at which surface regions (17, 18, 19) of mutually different structured regions of the component (10, 11, 12, 13) can be distinguished from one another by means of the height of the sensor signal (20), **characterized by** a component (10, 11, 12, 13) according to one of the claims 9 to 12.

14. Device according to claim 13, **characterized in that** the temperature sensor (14) is a sensor for controlling the temperature of the component and the control device (15) is set up in such a way that the identification can be determined or is determined from time fluctuations of the sensor signal.

## Revendications

1. Procédé d'individualisation d'un composant (10, 11, 12, 13), sachant que des zones de volume du composant (10, 11, 12, 13) attribuées à des zones voisines les unes des autres (17, 18, 19) du composant (10, 11, 12, 13) sont dotées de structures spatiales (7, 8, 9), qui peuvent être différenciées optiquement les unes des autres et forment au total en tant que système structural homogène dépendant une identification (16) individuelle lisible par ordinateur par un capteur (14), **caractérisé en ce que** le composant fait partie d'un dispositif pour le traitement thermique d'un substrat et l'identification est déterminée avec un capteur de température.

2. Procédé selon la revendication 1, **caractérisé en ce que** les structures sont formées par des surélévations (7) ou des cavités (8) disposées dans une surface extérieure du composant (10, 11, 12, 13), par la nature de surface de la surface extérieure et/ou par des creux (9) disposés dans le volume.

3. Procédé selon l'une quelconque des revendications 1 ou 2, **caractérisé en ce que** l'identification (16) est transformée par évaluation du signal de détection d'un capteur IR (14) en une suite de signes numériques ou alphanumériques multiples, sachant que la suite de signes contient en particulier des valeurs codées.

4. Procédé selon l'une quelconque des revendications 1 à 3, **caractérisé en ce que** l'identification (16) individuelle contient une valeur d'une grandeur physique avec des tolérances, laquelle grandeur peut être mesurée sur le composant (10, 11, 12, 13).

5. Procédé selon l'une quelconque des revendications 1 à 4, **caractérisé en ce qu'**une fonction de désactivation est déclenchée avec la saisie de l'identification individuelle (16).

6. Procédé selon la revendication 4, comportant les autres étapes de procédé suivantes :
- détermination de grandeurs physiques avec tolérances particulières du composant (10, 11, 12, 13) et/ou détermination des effets de la grandeur physique sur les valeurs des grandeurs de procédé lors du traitement thermique d'un substrat et des valeurs de correction pour la correction des paramètres de procédé,
- attribution des valeurs de correction et/ou des grandeurs physiques à l'identification individuelle (16),
- transmission de l'identification individuelle (16) et des grandeurs physiques et/ou des valeurs de correction au système de commande du procédé (15).

7. Procédé selon la revendication 6, comportant les autres étapes de procédé suivantes :
- incorporation dans le dispositif du composant (10, 11, 12, 13), qui porte l'identification individuelle (16),
- fermeture du dispositif (1),
- détermination de l'identification individuelle (16) du composant (10, 11, 12, 13) incorporé dans le dispositif,
- correction des paramètres de procédé en utilisant les grandeurs physiques et/ou les valeurs de correction transmises.

8. Composant (10, 11, 12, 13) pour l'exécution du procédé selon l'une quelconque des revendications 1 à 7, sachant que le composant (10, 11, 12, 13) comporte des zones, qui sont structurées avec des structures (7, 8, 9), qui sont formées par des surélévations (7) ou des cavités (8) disposées depuis une surface extérieure du composant (10, 11, 12, 13), par la nature de surface de la surface extérieure, qui peuvent être différenciées optiquement les unes des autres et forment au total en tant que système structural homogène dépendant, une identification (16) individuelle lisible par ordinateur par un capteur (14), **caractérisé en ce que** les structures (7, 8, 9) sont constituées de telle manière que les structures (7, 8, 9) peuvent être différenciées les unes des autres lors du traitement thermique en association avec un chauffage du composant (10, 11, 12, 13) avec un système de chauffage (5) à une température avec un capteur de température (14) à l'aide de la hauteur du signal de détection (20) du capteur de température (14) et l'identification (16) peut être déterminée, sachant que l'épaisseur du matériau et la conductibilité thermique du composant (10, 11, 12, 13) sont choisies de telle manière que les structures disposées sur une première surface extérieure du composant (10, 11, 12, 13) peuvent être identifiées par le capteur (14) sur une deuxième surface extérieure éloignée de la première surface extérieure.

9. Procédé selon la revendication 8 ou procédé selon l'une quelconque des revendications 1 à 7, **caractérisé en ce que** le composant (10, 11, 12, 13) du dispositif (1) est un suscepteur (10), une partie latérale (11), une couverture (12), une plaque de couverture (13) ou un autre composant d'une chambre de traitement de déposition chimique en phase vapeur (DPV) (2).

10. Composant selon l'une quelconque des revendications 8 ou 9 ou procédé selon l'une quelconque des revendications 1 à 7, **caractérisé en ce que** les structures (7, 8, 9) sont disposées le long d'une ligne en arc de cercle d'un composant (10) pouvant être entraîné en rotation autour du centre de la ligne en arc de cercle ou **en ce que** les structures (7, 8, 9) sont disposées le long d'une droite.

11. Composant selon l'une quelconque des revendications 8 à 10, **caractérisé en ce que** les zones sont des zones de surfaces structurées par rugosité, polissage ou par des pigments appliqués.

12. Composant selon l'une quelconque des revendications 8 à 11, **caractérisé en ce que** les zones s'allument en zone infrarouge lors du réchauffement du composant (10, 11, 12, 13), en particulier lors d'un flux thermique à travers le composant (10, 11, 12, 13).

13. Dispositif (1) de traitement thermique au moins d'un substrat (6) avec au moins un système de commande (15), qui est agencé pour exécuter un procédé selon l'une quelconque des revendications 1 à 8, un composant (10, 11, 12, 13), un capteur de température (14) et un système de chauffage (5), sachant que le composant (10, 11, 12, 13) peut être chauffé lors du traitement thermique avec le système de chauffage (5) à une température, à laquelle des zones de surface (17, 18, 19) de zones structurées différentes les unes des autres du composant (10, 11, 12, 13) peuvent être différenciées les unes des autres avec le capteur de température (14) à l'aide de la hauteur du signal de détection (20), **caractérisé par** un composant (10, 11, 12, 13) selon l'une quelconque des revendications 9 à 12.

14. Dispositif selon la revendication 13, **caractérisé en ce que** le capteur de température (14) est un capteur pour la régulation de la température du composant et le système de commande (15) est agencé de telle manière que l'identification peut être déterminée ou est déterminée à partir des variations temporelles du signal de détection.
